# EUROPEAN PATENT APPLICATION

(11) **EP 4 625 477 A1**
(43) Date of publication of application: **01.10.2025**
(21) Application number: 25165199.8
(22) Date of filing: 21.03.2025
(51) Int. Cl.: H01L 21/48, H01L 23/495, H01L 23/498, H01L 23/538, H01L 23/31, H01L 23/367, H01L 23/433, H01L 23/40

(54) **SEMICONDUCTOR PACKAGE DEVICE AND METHOD OF MANUFACTURING THE SAME**

(30) Priority: 28.03.2024 KR 20240042171; 24.02.2025 KR 20250023676
(71) Applicant: Silicon Box Pte. Ltd., Singapore 529580 (SG)
(72) Inventor: HAN, Byung Joon, 06067 SEOUL (KR); HAN, Young Michael, NEW YORK, 10010 (US); AHN, Byung Hoon, 16941 GYEONGGI-DO (KR)
(74) Representative: Cabinet Beaumont

(57) **Abstract**

Disclosed are a semiconductor package device and a method of manufacturing the same. The semiconductor package device includes a redistribution layer member, at least one chip disposed on a first surface of the redistribution layer member, the at least one chip being electrically connected to the redistribution layer member, a molding layer disposed on the first surface of the redistribution layer member so as to at least partially expose a backside of the at least one chip while filling a space around the at least one chip, a thermal interface material member disposed on the molding layer in contact with the backside of the at least one chip, and a heat spreading member disposed on the thermal interface material member.

## Description

### CROSS-REFERENCE TO RELATED APPLICATIONS

This application claims priority to Korean Patent Application No. 10-2024-0042171, filed on March 28, 2024, and Korean Patent Application No. 10-2025-0023676, filed on February 24, 2025, the entire contents of which are herein incorporated by reference.

### BACKGROUND OF THE INVENTION

### 1. Field of the invention

The present invention relates to a semiconductor device/electronic device and a method of manufacturing the same, and more particularly to a semiconductor package device and a method of manufacturing the same.

### 2. Description of the Related Art

A semiconductor process may be divided into a front-end process of manufacturing a wafer and engraving a circuit and a back-end process of packaging a chip. As semiconductor miniaturization technology approaches its limits in recent years, importance of the back-end process is further increasing.

Existing flip chip type semiconductor packaging may be performed by mounting a chip on a package substrate, forming an underfill material between the package substrate and the chip, and attaching a heat dissipation cover to the package substrate and the chip using an adhesive. The existing packaging is basically performed for each individual chip, and thus has a problem of greatly reduced process efficiency. In addition, the existing packaging has limitations and difficulties in improving thermal and electrical performance of a device.

Recently, as new chip manufacturing technologies have been developed, various new technologies have been proposed in terms of chip connection and power supply. For example, a technology that stacks a plurality of semiconductor chips through a connection structure such as a through silicon via (TSV) has been proposed, and a backside power delivery network (BSPDN) structure that supplies power through a backside of a semiconductor chip rather than a frontside of the semiconductor chip has been proposed. Along with the development of new manufacturing technologies, there have been raised many issues regarding thermal and electrical characteristics of package devices. However, there is a lack of technology capable of improving heat dissipation performance and electrical performance while increasing process efficiency in terms of semiconductor packaging.

### SUMMARY OF THE INVENTION

It is an object of the present invention to provide a semiconductor package device capable of improving thermal performance or thermal/electrical performance while increasing manufacturing efficiency and a method of manufacturing the same.

It is another object of the present invention to provide a semiconductor package device capable of effectively improving thermal performance or thermal/electrical performance, for example, in a fan-out package, and a method of manufacturing the same.

Objects of the present invention are not limited to the aforementioned objects, and other unmentioned objects will be understood by those skilled in the art based on the following description.

In accordance with one aspect of the present invention, the above and other objects can be accomplished by the provision of a semiconductor package device including a redistribution layer member, at least one chip disposed on a first surface of the redistribution layer member, the at least one chip being electrically connected to the redistribution layer member, a molding layer disposed on the first surface of the redistribution layer member so as to at least partially expose a backside of the at least one chip while filling a space around the at least one chip, a thermal interface material member disposed on the molding layer in contact with the backside of the at least one chip, and a heat spreading member disposed on the thermal interface material member.

The backside of the chip and a surface of the molding layer may be disposed on the same plane.

The molding layer may be formed on the first surface of the redistribution layer member with a larger thickness than the chip so as to cover the chip, and an opening configured to expose the backside of the chip may be formed in the molding layer.

The redistribution layer member may include at least one conductive contact element provided around an active region, at least one through-hole configured to expose the at least one conductive contact element may be formed in the molding layer or a stack of the molding layer and the thermal interface material member, and the through-hole may be filled with a material of the thermal interface material member or a material of the heat spreading member.

The heat spreading member may be thermally connected or thermally and electrically connected to the at least one conductive contact element through the at least one through-hole.

The at least one conductive contact element may include a stacked via structure.

The at least one conductive contact element may be a single conductive contact element, and the single conductive contact element may have a ring structure surrounding the active region.

The at least one conductive contact element may include a plurality of conductive contact elements disposed around the active region so as to be spaced apart from each other.

The heat spreading member may include a non-conductive material or a conductive material.

The heat spreading member may include a conductive material and may be used as an electrical connection member.

A plurality of electrical connection elements may be disposed on a second surface of the redistribution layer member, the second surface being opposite the first surface.

The semiconductor package device may have a fan-out package structure.

In accordance with another aspect of the present invention, there is provided a method of manufacturing a semiconductor package device, the method including preparing a device structure including a redistribution layer member, a plurality of chips, and a molding layer, wherein the redistribution layer member has a plurality of unit device regions, the plurality of chips is disposed on a first surface of the redistribution layer member so as to be electrically connected to the redistribution layer member, and the molding layer is disposed on the first surface of the redistribution layer member so as to at least partially expose a backside of each of the plurality of chips while filling spaces around the plurality of chips, forming a thermal interface material member configured to at least partially cover the plurality of unit device regions in contact with the backside of each of the plurality of chips on the molding layer, forming a heat spreading member configured to at least partially cover the plurality of unit device regions on the thermal interface material member, and dividing the device structure having the thermal interface material member and the heat spreading member formed therein into package devices corresponding respectively to the plurality of unit device regions.

The backside of the chip and a surface of the molding layer may be disposed on the same plane.

The molding layer may be formed on the first surface of the redistribution layer member with a larger thickness than the chip so as to cover the chip, and an opening configured to expose the backside of the chip may be formed in the molding layer.

In the step of preparing the device structure, an initial molding layer configured to cover the plurality of chips may be formed, and a grinding or ablation process may be performed on the initial molding layer to expose the backside of each of the plurality of chips.

The redistribution layer member may include at least one conductive contact element provided around an active region for each of the plurality of unit device regions, at least one through-hole configured to expose the at least one conductive contact element may be formed in the molding layer or a stack of the molding layer and the thermal interface material member for each of the plurality of unit device regions, and the through-hole may be filled with a material of the thermal interface material member or a material of the heat spreading member.

The heat spreading member may be thermally connected or thermally and electrically connected to the at least one conductive contact element through the at least one through-hole.

The at least one conductive contact element may include a stacked via structure.

The at least one conductive contact element may be a single conductive contact element for each of the plurality of unit device regions, and the single conductive contact element may have a ring structure surrounding the active region.

The at least one conductive contact element may include a plurality of conductive contact elements disposed around the active region so as to be spaced apart from each other for each of the plurality of unit device regions.

The heat spreading member may be used as an electrical connection member.

A plurality of electrical connection elements may be formed on a second surface of the redistribution layer member, the second surface being opposite the first surface.

The semiconductor package device may be manufactured using a fan-out packaging method.

### BRIEF DESCRIPTION OF THE DRAWINGS

FIG. 1 is a sectional view illustratively showing a semiconductor package device according to an embodiment of the present invention;
FIG. 2 is a sectional view illustratively showing a semiconductor package device according to another embodiment of the present invention;
FIG. 3 is a sectional view illustratively showing a semiconductor package device according to another embodiment of the present invention;
FIG. 4 is a sectional view illustratively showing a semiconductor package device according to another embodiment of the present invention;
FIG. 5 is a sectional view illustratively showing a semiconductor package device according to another embodiment of the present invention;
FIG. 6 is a sectional view illustratively showing a semiconductor package device according to another embodiment of the present invention;
FIG. 7 is a sectional view illustratively showing a semiconductor package device according to another embodiment of the present invention;
FIG. 8 is a sectional view illustratively showing a semiconductor package device according to another embodiment of the present invention;
FIG. 9 is a sectional view illustratively showing a semiconductor package device according to another embodiment of the present invention;
FIG. 10 is a plan view illustratively describing the configuration of a redistribution layer member that can be applied to a semiconductor package device according to an embodiment of the present invention;
FIG. 11 is a plan view illustratively describing the configuration of a redistribution layer member that can be applied to a semiconductor package device according to another embodiment of the present invention;
FIG. 12 is a sectional view illustratively showing a semiconductor package device according to another embodiment of the present invention;
FIG. 13 is a sectional view illustratively showing a semiconductor package device according to another embodiment of the present invention;
FIGs. 14A to 14D are sectional views illustratively showing a method of manufacturing a semiconductor package device according to an embodiment of the present invention;
FIGs. 15A to 15D are sectional views illustratively showing a method of manufacturing a semiconductor package device according to another embodiment of the present invention;
FIGs. 16A to 16D are sectional views illustratively showing a method of manufacturing a semiconductor package device according to another embodiment of the present invention; and
FIGs. 17A to 17E are sectional views illustratively showing a method of manufacturing a semiconductor package device according to another embodiment of the present invention.

### DETAILED DESCRIPTION OF THE PREFERRED EMBODIMENTS

Hereinafter, embodiments of the present invention will be described in detail with reference to the accompanying drawings.

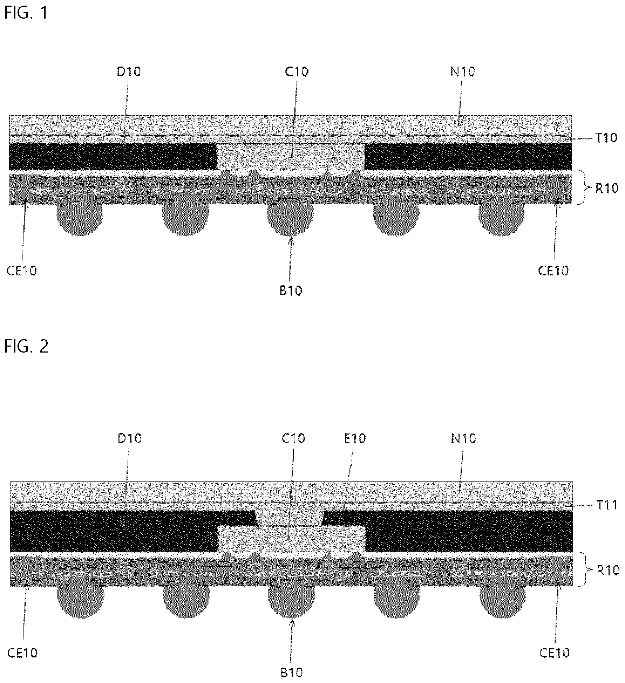

FIG. 1 is a sectional view illustratively showing a semiconductor package device according to an embodiment of the present invention.

Referring to FIG. 1, the semiconductor package device according to the embodiment of the present invention may include a redistribution layer (RDL) member R10, at least one chip (die) C10, a molding layer D10, a thermal interface material (TIM) member T10, and a heat spreading member N10.

The redistribution layer member R10 may serve to redistribute an electrode pad array of the chip C10. The redistribution layer member R10 may be formed through processes such as forming an insulating layer having a via hole (opening), forming a seed layer, forming a mask pattern, electroplating a wiring layer, and removing the mask pattern. The redistribution layer member R10 may include a structure in which an insulating layer (e.g., an organic insulating layer) and a wiring member layer (wiring element layer) are alternately stacked at least once. The insulating layer may have a plurality of via holes (openings) formed therein, and conductive via elements may be provided in the via holes. The conductive via element may serve as a vertical wire. The conductive via element may also be referred to as a "via-type wire" or a "via plug." The insulating layer in direct contact with the chip C10 may also be referred to as a passivation layer. The passivation layer may be considered to be included in the redistribution layer member R10, but this may not be the case.

The redistribution layer member R10 may have at least one conductive contact element CE10 around an active region. The conductive contact element CE10 may be disposed around the active region, and in this regard, the conductive contact element may be referred to as a "surrounding contact element." The conductive contact element CE10 may serve to extend a conduction path, and may serve to improve efficiency of a plating process when the redistribution layer member R10 is formed. In addition, the conductive contact element CE10 may serve to suppress/prevent poor wiring by suppressing/preventing unevenness of the insulating layer and improving flatness of the insulating layer when the redistribution layer member R10 is formed. Furthermore, the conductive contact element CE10 may be used as an electrical contact and/or thermal path.

The at least one chip C10 may be disposed on a first surface of the redistribution layer member R10 so as to be electrically connected to the redistribution layer member R10. Here, the case where one chip C10 is provided is shown. The chip C10 may be a semiconductor chip, and may also be referred to as a die. Electrode pads formed on a frontside (front surface) of the chip C10 may be disposed so as to face the redistribution layer member R10. The first surface of the redistribution layer member R10 may be any one of two main surfaces (an upper surface and a lower surface) of the redistribution layer member R10.

The molding layer D10 may be disposed on the first surface of the redistribution layer member R10 so as to surround the perimeter of the chip C10. The molding layer D10 may be disposed on the first surface of the redistribution layer member R10 so as to at least partially expose a backside (back surface) of the chip C10 while filling a space around the chip C10. At least a part of the backside of the chip C10 may not be covered by the molding layer D10. The molding layer D10 may include a polymer material. For example, the molding layer D10 may include a molding compound.

The thermal interface material (TIM) member T10 may be disposed on the molding layer D10 in contact with the backside of the at least one chip C10. The thermal interface material member T10 may be in direct contact with the backside of the chip C10. The thermal interface material member T10 may have a larger size than the chip C10 and may have a kind of layered form. The thermal interface material member T10 may be disposed on the entire surface or substantially the entire surface of the molding layer D10. Heat may be transferred from the backside of the chip C10 to the thermal interface material member T10.

The material of the thermal interface material member T10 may be in the form of a resin-filler composite obtained by mixing a maximum of about 85 wt% of thermally conductive particles (filler) into a resin material such as epoxy, silicone, or urethane. The thermally conductive particles (filler) may include, without being limited to, at least one material selected from the group consisting, for example, of alumina, aluminum nitride, and boron nitride. The thermal interface material member T10 may be a resin-filler composite. However, the embodiment of the present invention is not limited thereto, and various types of thermal interface materials may be used. The material of the thermal interface material member T10 may have a liquid, adhesive, putty, or solid form.

The heat spreading member N10 may be disposed on the thermal interface material member T10. The thermal interface material member T10 may be disposed between a heating element and the heat spreading member N10 and may serve to transfer heat generated by the heating element to the heat spreading member N10. Here, the heating element may include the chip C10. In addition, the thermal interface material member T10 may serve to fix the heat spreading member N10. The heat spreading member N10 may have a larger size than the chip C10 and may have a kind of layered form. The heat spreading member N10 may be disposed on the entire surface or substantially the entire surface of the thermal interface material member T10.

The heat spreading member N10 may be made of a material having excellent thermal conductivity. The heat spreading member N10 may include a non-conductive material or a conductive material. Here, "non-conductive" and "conductive" may refer to "electrically non-conductive" and "electrically conductive," respectively. For example, the heat spreading member N10 may include at least one of alumina, aluminum nitride, aluminum, and copper. However, the material of the heat spreading member N10 is not limited thereto and may be varied. Materials applicable to a typical heat spreader, heat sink, or heat dissipation member may be used as the materials of the heat spreading member N10. The heat spreading member N10 may be referred to as a heat spreader, a heat sink, or a heat dissipation member.

A plurality of electrical connection elements B10 may be disposed on a second surface of the redistribution layer member R10, which is opposite the first surface. Here, the second surface may be any one of the two main surfaces (the upper surface and the lower surface) of the redistribution layer member R10. As a non-limiting example, each of the plurality of electrical connection elements B10 may include a solder ball or a bump. According to an example, the plurality of electrical connection elements B10 may be attached to an under bump metallurgy (UBM) layer. The plurality of electrical connection elements B10 may be connected to a predetermined circuit board. As needed, the conductive contact element CE10 of the redistribution layer member R10 may be electrically connected to at least one of the plurality of electrical connection elements B10 by a wiring structure of the redistribution layer member R10.

According to an embodiment, the backside of the chip C10 and the surface of the molding layer D10 may be disposed on the same plane. In other words, the backside of the chip C10 and the surface of the molding layer D10 may be disposed to form substantially the same plane at substantially the same height. For example, after forming an initial molding layer covering the chip C10, a grinding or ablation process may be performed on the initial molding layer to expose the backside of the chip C10. The backside of the chip C10 and the surface of the molding layer D10 may be disposed on substantially the same plane, and the thermal interface material member T10 may be formed on a substantially flat surface.

The semiconductor package device according to the embodiment of the present invention may have a fan-out package structure. In other words, the overall size (width) of the semiconductor package device may be greater than the size (width) of the chip C10, and the plurality of electrical connection elements B10 may be disposed so as to exceed the size of the chip C10. The semiconductor package device may be manufactured using panel-level packaging (PLP) or wafer-level packaging (WLP).

FIG. 2 is a sectional view illustratively showing a semiconductor package device according to another embodiment of the present invention. The semiconductor package device according to this embodiment has a structure in which a part of the structure of FIG. 1 is modified. The modified structure will be described with reference to FIG. 2.

Referring to FIG. 2, a molding layer D10 may be formed on a first surface of a redistribution layer member R10 with a larger thickness than a chip C10 so as to cover the chip C10, and an opening E10 configured to expose a backside of the chip C10 may be formed in the molding layer D10. The opening E10 may be formed directly above the chip C10. The opening E10 may be formed, for example, through an ablation process using a laser. A relatively large region of the backside of the chip C10 may be exposed through the opening E10. A thermal interface material member T11 may be disposed on the molding layer D10 so as to fill the opening E10. The thermal interface material member T11 may be in contact with the backside of the chip C10 through the opening E10.

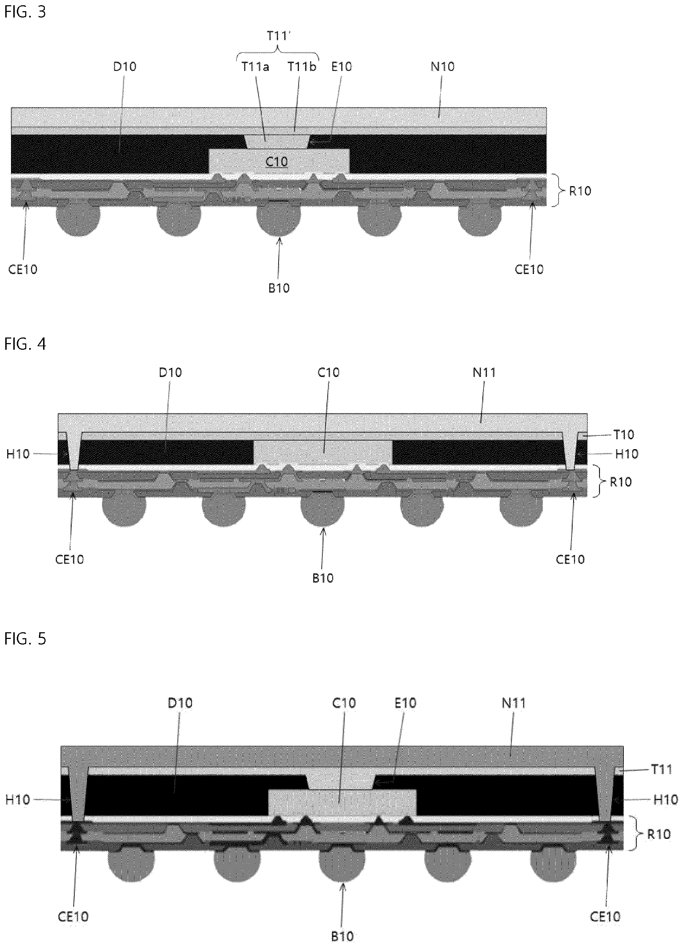

FIG. 3 is a sectional view illustratively showing a semiconductor package device according to another embodiment of the present invention.

Referring to FIG. 3, the semiconductor package device according to this embodiment may have a structure similar to that of FIG. 2. However, a thermal interface material member T11' may include a first thermal interface material member T11a disposed in an opening E10 and a second thermal interface material member T11b disposed outside the opening E10. The second thermal interface material member T11b may be a layer formed separately from the first thermal interface material member T11a. The second thermal interface material member T11b may be disposed on the first thermal interface material member T11a and a molding layer D10. The first and second thermal interface material members T11a and T11b may be made of the same material or different materials.

FIG. 4 is a sectional view illustratively showing a semiconductor package device according to another embodiment of the present invention. The semiconductor package device according to this embodiment has a structure in which a part of the structure of FIG. 1 is modified.

Referring to FIG. 4, at least one through-hole H10 configured to expose at least one conductive contact element CE10 may be formed in a stack of a molding layer D10 and a thermal interface material member T10. The through-hole H10 may be a vertical hole or a kind of via hole. The through-hole H10 may be referred to as a through mold via (TMV). A plurality of through-holes H10 may be formed as needed. The through-hole H10 may be formed through an optical drilling or mechanical drilling process. As an example, the through-hole H10 may be formed through a drilling process using a laser. The through-hole H10 may be formed so as to extend to a part of a redistribution layer member R10 while being formed through the thermal interface material member T10 and the molding layer D10. On the assumption that an intermediate layer (passivation layer) is present between the redistribution layer member R10 and the molding layer D10, the through-hole H10 may be formed through the intermediate layer (passivation layer) while being formed through the molding layer D10.

A heat spreading member N11 may be disposed on the thermal interface material member T10, and the through-hole H10 may be filled with a material of the heat spreading member N11. The heat spreading member N11 may be thermally connected or thermally and electrically connected to the at least one conductive contact element CE10 through the at least one through-hole H10. If the heat spreading member N11 includes a conductive material, the heat spreading member N11 may be electrically connected to the at least one conductive contact element CE10. At this time, the heat spreading member N11 may be used as an electrical connection member. As a non-limiting example, the heat spreading member N11 may have the characteristics (function) of a power wire, a ground wire, or a drain wire.

According to an embodiment, the at least one conductive contact element CE10 may include a stacked via structure. In other words, the conductive contact element CE10 may include a structure in which a plurality of via plugs is stacked in a vertical direction. In addition, the conductive contact element CE10 may further include a via land for contact, i.e., a via extension portion.

According to an embodiment, the at least one conductive contact element CE10 may have the characteristics (function) of a wire. In addition to or separately from this, the at least one conductive contact element CE10 may be used as a kind of thermal path. If the conductive contact element CE10 is used as a thermal path, heat generated from the redistribution layer R10, etc. may be easily dissipated through the heat spreading element N11, whereby thermal and electrical performance of the semiconductor package device may be improved.

FIG. 5 is a sectional view illustratively showing a semiconductor package device according to another embodiment of the present invention. The semiconductor package device according to this embodiment has a structure in which a part of the structure of FIG. 2 is modified.

Referring to FIG. 5, at least one through-hole H10 configured to expose at least one conductive contact element CE10 may be formed in a stack of a molding layer D10 and a thermal interface material member T11. The through-hole H10 may be formed so as to extend to a part of a redistribution layer member R10 while being formed through the thermal interface material member T11 and the molding layer D10. A heat spreading member N11 may be disposed on the thermal interface material member T11, and the through-hole H10 may be filled with a material of the heat spreading member N11. The heat spreading member N11 may be thermally connected or thermally and electrically connected to the at least one conductive contact element CE10 through the at least one through-hole H10. If the heat spreading member N11 includes a conductive material, the heat spreading member N11 may be electrically connected to the at least one conductive contact element CE10. At this time, the heat spreading member N11 may be used as an electrical connection member.

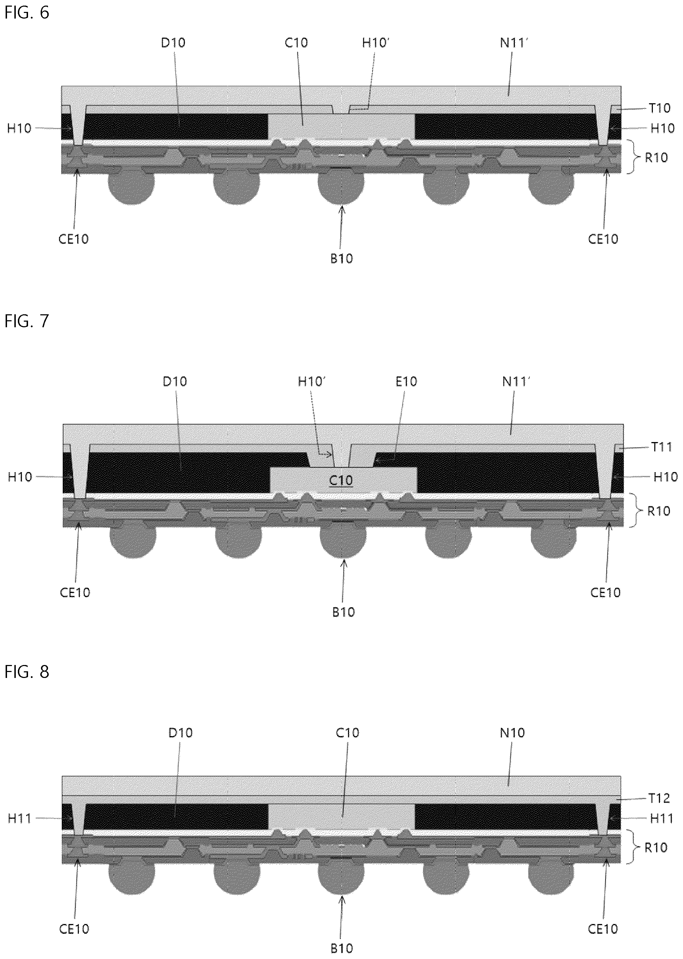

FIG. 6 is a sectional view illustratively showing a semiconductor package device according to another embodiment of the present invention. The semiconductor package device according to this embodiment has a structure in which a part of the structure of FIG. 4 is modified.

Referring to FIG. 6, a separate through-hole H10' configured to expose a backside of a chip C10 may be further formed in a thermal interface material member T10. The separate through-hole H10' may be formed directly above the chip C10. A heat spreading member N11' may be partially connected to (in contact with) the backside of the chip C10 through the separate through-hole H10'. If the heat spreading member N11' is made of a conductive material, the heat spreading member N11' may be electrically connected to a conductive contact element CE10 through a through-hole H10, and may also be electrically connected to the backside of the chip C10 through the separate through-hole H10'. The heat spreading member N11' may be used as an electrical connection member. In this case, as a non-limiting example, the heat spreading member N11' may have the characteristics (function) of a power wire, a ground wire, or a drain wire.

FIG. 7 is a sectional view illustratively showing a semiconductor package device according to another embodiment of the present invention. The semiconductor package device according to this embodiment has a structure in which a part of the structure of FIG. 5 is modified.

Referring to FIG. 7, a separate through-hole H10' configured to expose a backside of a chip C10 may be further formed in a thermal interface material member T11. The separate through-hole H10' may be formed directly above the chip C10. The separate through-hole H10' may be formed through an opening E10, but the present invention is not limited thereto. The separate through-hole H10' may have a smaller width (diameter) than the opening E10. A heat spreading member N11' may be partially connected to (in contact with) the backside of the chip C10 through the separate through-hole H10'. If the heat spreading member N11' is made of a conductive material, the heat spreading member N11' may be electrically connected to a conductive contact element CE10 through a through-hole H10, and may also be electrically connected to the backside of the chip C10 through the separate through-hole H10'. The heat spreading member N11' may be used as an electrical connection member.

FIG. 8 is a sectional view illustratively showing a semiconductor package device according to another embodiment of the present invention. The semiconductor package device according to this embodiment has a structure in which a part of the structure of FIG. 1 is modified.

Referring to FIG. 8, at least one through-hole H11 configured to expose at least one conductive contact element CE10 of a redistribution layer member R10 may be formed in a molding layer D10. The through-hole H11 may be a vertical hole or a kind of via hole. The through-hole H11 may be referred to as a through mold via (TMV). A plurality of through-holes H11 may be formed as needed. The through-hole H11 may be formed through an optical drilling or mechanical drilling process. As an example, the through-hole H10 may be formed through a drilling process using a laser. The through-hole H11 may be formed so as to extend to a part of the redistribution layer member R10 while being formed through the molding layer D10. On the assumption that an intermediate layer (passivation layer) is present between the redistribution layer member R10 and the molding layer D10, the through-hole H11 may be formed through the intermediate layer (passivation layer) while being formed through the molding layer D10.

A thermal interface material member T12 may be disposed on the molding layer D10, and the through-hole H11 may be filled with a material of the thermal interface material member T12. A heat spreading member N10 may be thermally connected or thermally and electrically connected to the at least one conductive contact element CE10 through the at least one through-hole H11. If the thermal interface material member T12 is made of a non-conductive (electrically non-conductive) material, the heat spreading member N10 may be thermally connected to the conductive contact element CE10 through the through-hole H11.

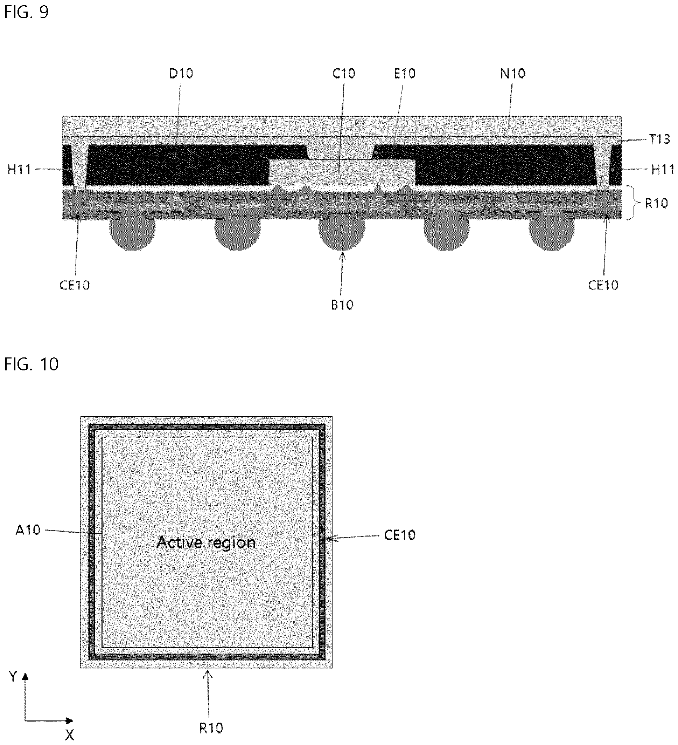

FIG. 9 is a sectional view illustratively showing a semiconductor package device according to another embodiment of the present invention. The semiconductor package device according to this embodiment has a structure in which a part of the structure of FIG. 2 is modified.

Referring to FIG. 9, at least one through-hole H11 configured to expose at least one conductive contact element CE10 of a redistribution layer member R10 may be formed in a molding layer D10. The through-hole H11 may be formed so as to extend to a part of the redistribution layer member R10 while being formed through the molding layer D10. A thermal interface material member T13 may be disposed on the molding layer D10, and the through-hole H11 may be filled with a material of the thermal interface material member T13. A heat spreading member N10 may be thermally connected or thermally and electrically connected to the at least one conductive contact element CE10 through the at least one through-hole H11. If the thermal interface material member T13 is made of a non-conductive (electrically non-conductive) material, the heat spreading member N10 may be thermally connected to the conductive contact element CE10 through the through-hole H11.

FIG. 10 is a plan view illustratively describing the configuration of a redistribution layer member that can be applied to a semiconductor package device according to an embodiment of the present invention.

Referring to FIG. 10, the redistribution layer member R10 that can be applied to the semiconductor package device according to the embodiment of the present invention may have an active region A10, and may be provided with at least one conductive contact element CE10 around the active region A10. The conductive contact element CE10 may be referred to as a "surrounding contact element."

In this embodiment, the at least one conductive contact element CE10 may be a single conductive contact element. The conductive contact element CE10 corresponding to the single conductive contact element may have a ring structure surrounding the active region A10, when viewed from above. The conductive contact element CE10 may have a seal ring structure that completely surrounds the active region A10. For example, the conductive contact element CE10 may have a quadrangular ring structure, a similar structure thereto, or a modified structure thereof.

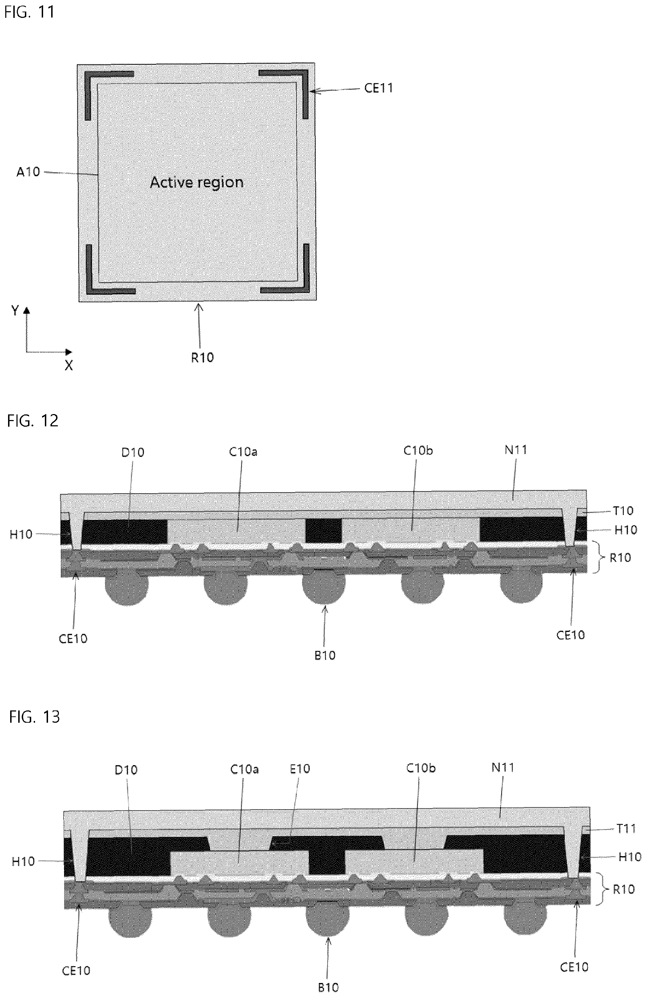

FIG. 11 is a plan view illustratively describing the configuration of a redistribution layer member that can be applied to a semiconductor package device according to another embodiment of the present invention.

Referring to FIG. 11, the redistribution layer member R10 may include a plurality of conductive contact elements CE11 disposed around an active region A10 so as to be spaced apart from each other. The plurality of conductive contact elements CE11 may be configured to partially surround the active region A10. The position, shape, and number of the plurality of conductive contact elements CE11 are illustrative and may be varied. One or more conductive contact elements CE11 may be formed at selected positions in an allowable region (space) around the active region A10.

FIGs. 1 to 9 show the case where the semiconductor package device includes one chip (a single chip), but a semiconductor package device according to another embodiment may include a plurality of chips (multiple chips). The case where the semiconductor package device includes a plurality of chips (multiple chips) is shown in FIGs. 12 and 13.

FIGs. 12 and 13 are sectional views illustratively showing semiconductor package devices according to other embodiments of the present invention. FIG. 12 shows the case in which the device of FIG. 4 is modified to have a multi-chip structure, and FIG. 13 shows the case in which the device of FIG. 5 is modified to have a multi-chip structure.

Referring to FIGs. 12 and 13, the semiconductor package device according to the embodiment may include a plurality of chips C10a and C10b disposed on a first surface of a redistribution layer member R10. The plurality of chips C10a and C10b may include two or more chips. A molding layer D10 may be disposed on the first surface of the redistribution layer member R10 so as to fill spaces around the plurality of chips C10a and C10b. A thermal interface material member T10 or T11 may be disposed on the molding layer D10, and a heat spreading member N11 may be disposed on the thermal interface material member T10 or T11.

At least two features of the embodiments of FIGs. 1 to 13 described above may be mutually combined within a non-contradictory range. In addition, although the case in which one semiconductor package device includes one heat spreading member has been shown and described in the aforesaid embodiments, a plurality of heat spreading members may be applied to one semiconductor package device in some cases. Furthermore, in some cases, the semiconductor chip may have a structure in which a plurality of chips is stacked.

According to the embodiment of the present invention, for example, in a fan-out semiconductor package, it is possible to improve thermal performance using the thermal interface material (TIM) member in contact with a backside of the chip and the heat spreading member disposed on the thermal interface material member. In addition, according to the embodiment of the present invention, it is possible to improve thermal/electrical performance of the package device using thermal/electrical connection by a through mold via (TMV) in conjunction with the thermal interface material (TIM) member and the heat spreading member.

Existing flip chip type semiconductor packaging may be performed by mounting a chip on a package substrate, forming an underfill material between the package substrate and the chip, and attaching a heat dissipation cover to the package substrate and the chip using an adhesive. The existing packaging is basically performed for each individual chip, and thus has a problem of greatly reduced process efficiency. In addition, the existing packaging has limitations and difficulties in improving thermal and electrical performance of a device. The embodiment of the present invention is capable of overcoming the disadvantages of the existing packaging. According to the embodiment of the present invention, it is possible to provide a semiconductor package device capable of increasing manufacturing efficiency and productivity while improving thermal performance or thermal/electrical performance and a method of manufacturing the same.

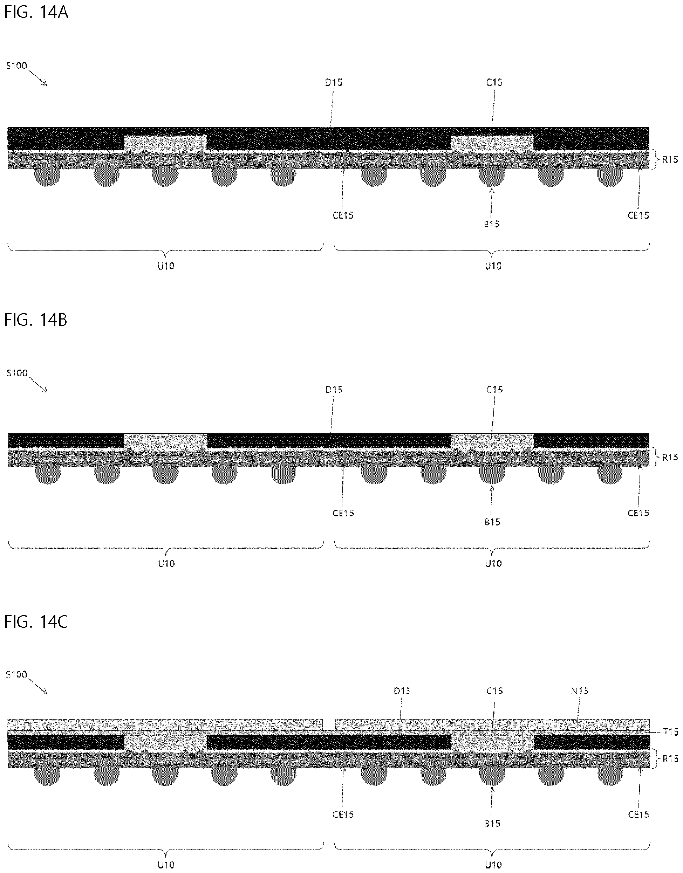

FIGs. 14A to 14D are sectional views illustratively showing a method of manufacturing a semiconductor package device according to an embodiment of the present invention.

Referring to FIG. 14A, a device structure S100 including a redistribution layer member R15, a plurality of chips C15, and a molding layer D15 may be prepared. The device structure S100 may be formed using fan-out packaging. For example, the device structure S100 may be formed using fan-out panel level packaging (FOPLP) or fan-out wafer level packaging (FOWLP). As a specific example, a plurality of chips C15 may be attached to a predetermined carrier substrate, a molding layer D15 covering the plurality of chips C15 may be formed on the carrier substrate, the plurality of chips C15 and the molding layer D15 may be separated from the carrier substrate, and a redistribution layer member R15 electrically connected to the plurality of chips C15 may be formed. The plurality of chips C15 may be attached to the carrier substrate, for example, in a face-down manner. In addition, when forming the device structure S100, a chip-first (i.e., die-first) method or a chip-last (i.e., die-last) method may be applied.

The redistribution layer member R15 may be formed through processes such as forming an insulating layer having a via hole (opening), forming a seed layer, forming a mask pattern, electroplating a wiring layer, and removing the mask pattern. The redistribution layer member R15 may include a structure in which an insulating layer (e.g., an organic insulating layer) and a wiring member layer (wiring element layer) are alternately stacked at least once. The insulating layer may have a plurality of via holes (openings) formed therein, and conductive via elements may be provided in the via holes. The conductive via element may serve as a vertical wire. The insulating layer in direct contact with the chip C15 may also be referred to as a passivation layer. The passivation layer may be considered to be included in the redistribution layer member R15, but this may not be the case.

The redistribution layer member R15 may have a plurality of unit device regions U10. The plurality of unit device regions U10 may be two-dimensionally disposed. The redistribution layer member R15 may have at least one conductive contact element CE15 around an active region for each of the plurality of unit device regions U10. The conductive contact element CE15 may be disposed around the active region, and therefore the conductive contact element may be referred to as a "surrounding contact element."

The plurality of chips C15 may be disposed on a first surface of the redistribution layer member R15 so as to be electrically connected to the redistribution layer member R15. At least one chip C15 may be disposed in each of the plural unit device regions U10. Here, the case in which one chip C15 is provided in one unit device region U10 is shown. Electrode pads formed on a frontside (front surface) of the chip C15 may be disposed so as to face the redistribution layer member R15.

The molding layer D15 may be disposed on the first surface of the redistribution layer member R15 so as to surround the perimeters of the plurality of chips C15. The molding layer D15 may be formed on the first surface of the redistribution layer member R15 so as to cover the plurality of chips C15. The height of the molding layer D15 may be greater than the height of the chip C15. Consequently, a side surface and a backside of the chip C15 may be covered by the molding layer D15. The molding layer D15 may include a polymer material. For example, the molding layer D15 may include a molding compound.

According to an example, a plurality of electrical connection elements B15 may be formed (disposed) on a second surface of the redistribution layer member R15, which is opposite the first surface. As a non-limiting example, each of the plurality of electrical connection elements B15 may include a solder ball or a bump. The plurality of electrical connection elements B15 may be attached to an under bump metallurgy (UBM) layer. In some cases, the time of formation of the plurality of electrical connection elements B15 may be varied.

Referring to FIG. 14B, a grinding or ablation process may be performed on the molding layer D15 to expose at least a part of the backside of each of the plurality of chips C15. The molding layer D15 formed so as to cover the plurality of chips C15 in the step of FIG. 14A may be referred to as an initial molding layer, and the backside of each of the plurality of chips C15 may be exposed through the grinding or ablation process for the initial molding layer. However, in some cases, the molding process may be performed such that the backside of the chip C15 is exposed. In other words, the molding layer may be formed in the same shape as shown in FIG. 14B from the beginning. In this case, processes such as grinding or ablation may not be required.

In this step, the molding layer D15 may be disposed on the first surface of the redistribution layer member R15 so as to expose the backside of each of the plurality of chips C15 while filling spaces around the plurality of chips C15. The backside of the chip C15 may be exposed without being covered by the molding layer D15. The backside of the chip C15 and the surface of the molding layer D15 may be disposed on the same plane. In other words, the backside of the chip C15 and the surface of the molding layer D15 may be disposed to form substantially the same plane at substantially the same height.

Referring to FIG. 14C, a thermal interface material member T15 configured to at least partially cover the plurality of unit device regions U10 in contact with the backside of each of the plurality of chips C15 may be formed on the molding layer D15. The thermal interface material member T15 may be in direct contact with the backside of the chip C15. The material of the thermal interface material member T15 may be in the form of a resin-filler composite obtained by mixing thermally conductive particles (filler) into a resin material such as epoxy, silicone, or urethane. The thermally conductive particles (filler) may include, without being limited to, at least one material selected from the group consisting of, for example, alumina, aluminum nitride, and boron nitride. The thermal interface material member T15 may be a resin-filler composite. However, the embodiment of the present invention is not limited thereto, and various types of thermal interface materials may be used. The material of the thermal interface material member T15 may have a liquid, adhesive, putty, or solid form.

The thermal interface material member T15 may be disposed on the entire surface or substantially the entire surface of the molding layer D15. Alternatively, the thermal interface material member T15 may be provided in plural, in which case each of the plurality of thermal interface material members may cover a corresponding one of the plurality of unit device regions U10.

Subsequently, a heat spreading member N15 configured to at least partially cover the plurality of unit device regions U10 may be formed on the thermal interface material member T15. The heat spreading member N15 may be made of a material having excellent thermal conductivity. The heat spreading member N15 may include a non-conductive material or a conductive material. Here, "non-conductive" and "conductive" may refer to "electrically non-conductive" and "electrically conductive," respectively. For example, the heat spreading member N15 may include at least one of alumina, aluminum nitride, aluminum, and copper. However, the material of the heat spreading member N15 is not limited thereto and may be varied. Materials applicable to a typical heat spreader, heat sink, or heat dissipation member may be used as the materials of the heat spreading member N15.

The heat spreading member N15 may be formed using an attachment (bonding) method. Alternatively, the heat spreading member N15 may be formed using any one of a sputtering method, a coating method, and a plating method. In forming the heat spreading member N15, a damascene process may be employed if necessary. However, the specific method of forming the heat spreading member N15 is not limited thereto and may be varied depending on the circumstances. The heat spreading member N15 may be provided in plural. Each of the plurality of heat spreading members N15 may be disposed on a corresponding one of the plurality of unit device regions U10.

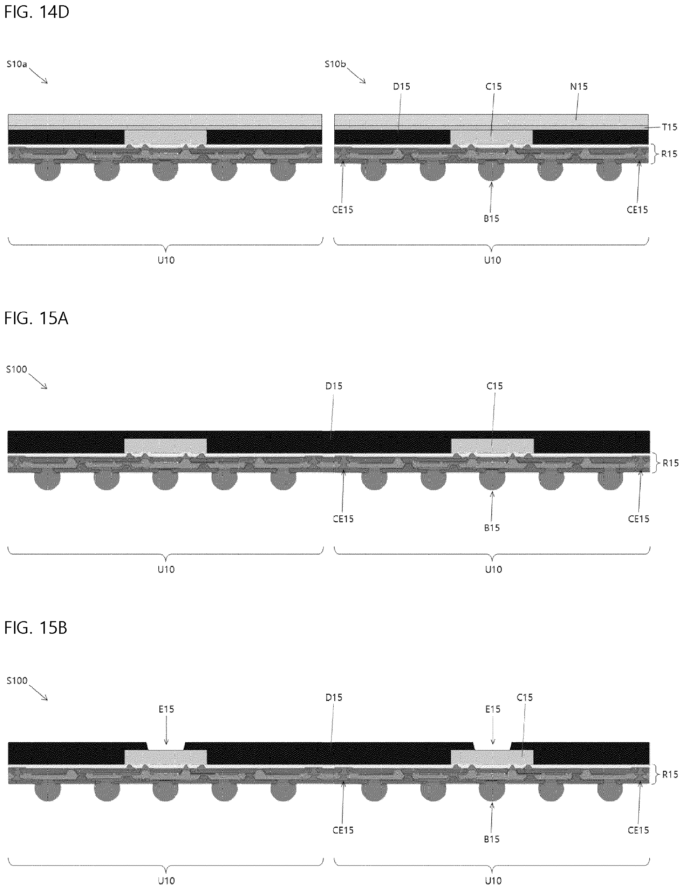

Referring to FIG. 14D, the device structure S100 (FIG. 14C) in which the thermal interface material member T15 and the heat spreading member N15 are formed may be divided (cut) into package devices corresponding respectively to the plurality of unit device regions U10. This may be performed according to a general dividing (cutting) method. As a result, individual semiconductor package devices S10a and S10b may be obtained. Each of the semiconductor package devices S10a and S10b may have the configuration described with reference to FIG. 1.

FIGs. 15A to 15D are sectional views illustratively showing a method of manufacturing a semiconductor package device according to another embodiment of the present invention.

Referring to FIG. 15A, a device structure S100 as described with reference to FIG. 14A may be prepared. The device structure S100 may include a redistribution layer member R15, a plurality of chips C15, and a molding layer D15. The molding layer D15 may be formed on a first surface of the redistribution layer member R15 with a larger thickness than the chip C15 so as to cover the chip C15. The molding layer D15 may be referred to as an initial molding layer.

Referring to FIG. 15B, an opening E15 configured to expose a backside of the chip C15 may be formed in the molding layer D15. A plurality of openings E15 may be formed to expose the backsides of the plurality of chips C15, respectively. The opening E15 may be formed, for example, through an ablation process using a laser. A relatively large region of the backside of the chip C10 may be exposed through the opening E15.

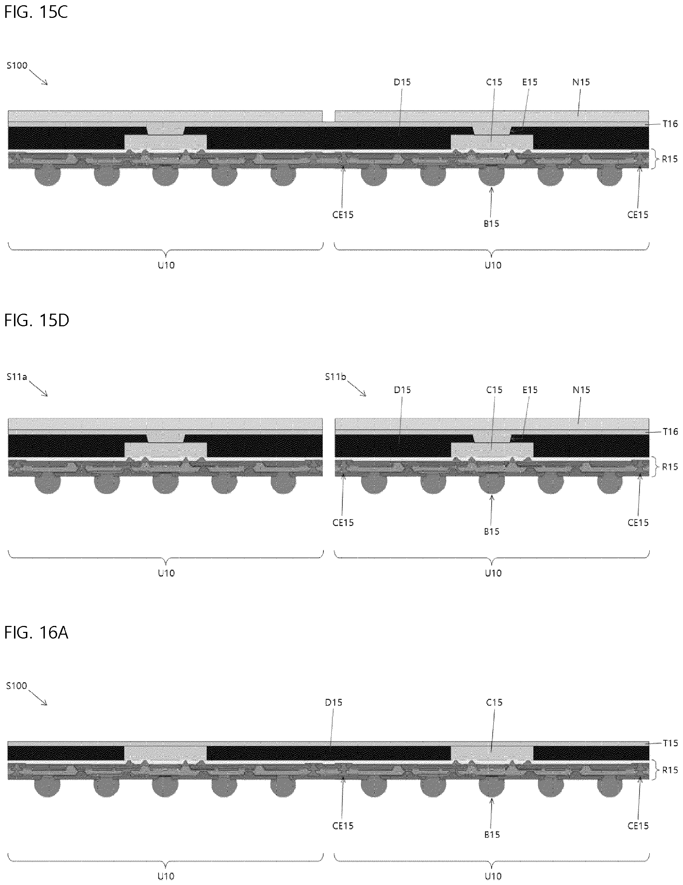

Referring to FIG. 15C, a thermal interface material member T16 configured to at least partially cover a plurality of unit device regions U10 in contact with the backside of each of the plurality of chips C15 may be formed on the molding layer D15. The thermal interface material member T16 may be disposed on the molding layer D15 so as to fill the opening E15. The thermal interface material member T16 may be in contact with the backside of the chip C15 through the opening E15. Subsequently, a heat spreading member N15 configured to at least partially cover the plurality of unit device regions U10 may be formed on the thermal interface material member T16.

Referring to FIG. 15D, the device structure S100 (FIG. 15C) in which the thermal interface material member T16 and the heat spreading member N15 are formed may be divided (cut) into package devices corresponding respectively to the plurality of unit device regions U10. As a result, individual semiconductor package devices S11a and S11b may be obtained. Each of the semiconductor package devices S11a and S11b may have the configuration described with reference to FIG. 2.

FIGs. 16A to 16D are sectional views illustratively showing a method of manufacturing a semiconductor package device according to another embodiment of the present invention.

Referring to FIG. 16A, a device structure S100 corresponding to FIG. 14B may be prepared. The device structure S100 may include a redistribution layer member R15, a plurality of chips C15, and a molding layer D15. A thermal interface material member T15 may be formed on the molding layer D15. The thermal interface material member T15 may be formed in the same manner as described with reference to FIG. 14C.

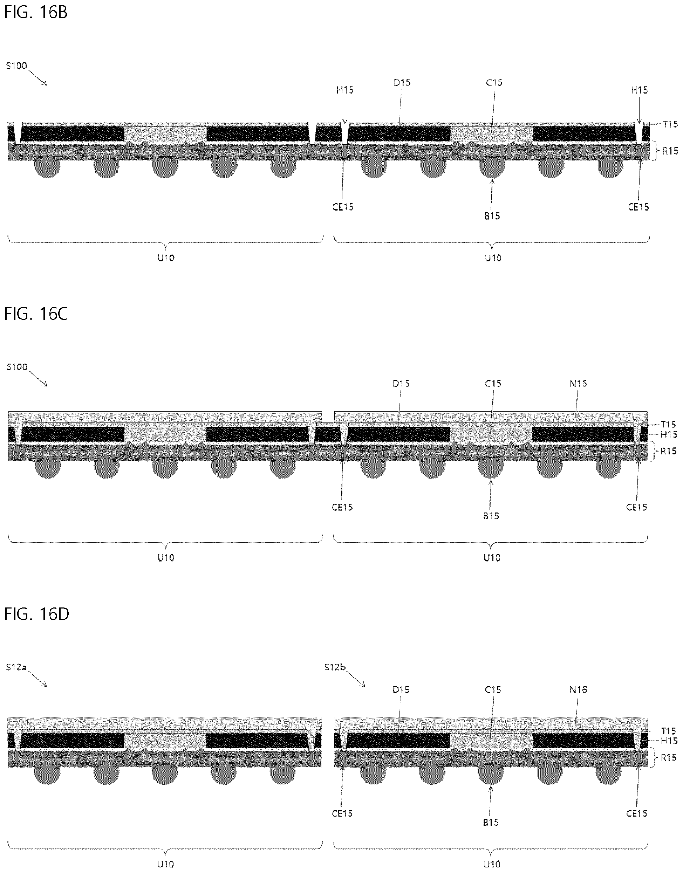

Referring to FIG. 16B, at least one through-hole H15 configured to expose at least one conductive contact element CE15 may be formed in a stack of the molding layer D15 and the thermal interface material member T15 for each of a plurality of unit device regions U10. A plurality of through-holes H15 may be formed. The through-hole H15 may be a vertical hole or a kind of via hole. The through-hole H15 may be referred to as a through mold via (TMV). The through-hole H15 may be formed through an optical drilling or mechanical drilling process. As an example, the through-hole H15 may be formed through a drilling process using a laser. The through-hole H15 may be formed so as to extend to a part of the redistribution layer member R15 while being formed through the thermal interface material member T15 and the molding layer D15. On the assumption that an intermediate layer (passivation layer) is present between the redistribution layer member R15 and the molding layer D15, the through-hole H15 may be formed through the intermediate layer (passivation layer) while being formed through the molding layer D15.

Referring to FIG. 16C, a heat spreading member N16 configured to at least partially cover the plurality of unit device regions U10 may be formed on the thermal interface material member T15. For each of the plurality of unit device regions U10, the heat spreading member N16 may be formed on the thermal interface material member T15. The through-hole H15 may be filled with a material of the heat spreading member N16. The heat spreading member N16 may be thermally connected or thermally and electrically connected to the at least one conductive contact element CE15 through the at least one through-hole H15. If the heat spreading member N16 includes a conductive material, the heat spreading member N16 may be electrically connected to the at least one conductive contact element CE15. At this time, the heat spreading member N16 may be used as an electrical connection member.

Referring to FIG. 16D, the device structure S100 (FIG. 16C) in which the thermal interface material member T15 and the heat spreading member N16 are formed may be divided (cut) into package devices corresponding respectively to the plurality of unit device regions U10. As a result, individual semiconductor package devices S12a and S12b may be obtained. Each of the semiconductor package devices S12a and S12b may have the configuration described with reference to FIG. 4.

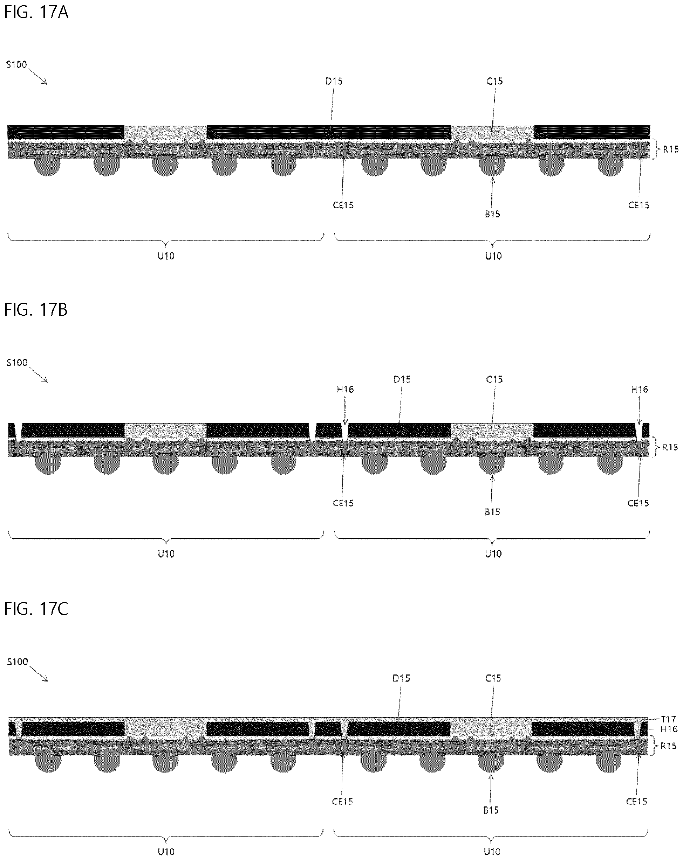

FIGs. 17A to 17E are sectional views illustratively showing a method of manufacturing a semiconductor package device according to another embodiment of the present invention.

Referring to FIG. 17A, a device structure S100 corresponding to FIG. 14B may be prepared. The device structure S100 may include a redistribution layer member R15, a plurality of chips C15, and a molding layer D15.

Referring to FIG. 17B, at least one through-hole H16 configured to expose at least one conductive contact element CE15 may be formed in the molding layer D15 for each of a plurality of unit device regions U10. A plurality of through-holes H16 may be formed. The through-hole H16 may be referred to as a through mold via (TMV). The through-hole H16 may be formed through an optical drilling or mechanical drilling process. As an example, the through-hole H16 may be formed through a drilling process using a laser. The through-hole H16 may be formed so as to extend to a part of the redistribution layer member R15 while being formed through the molding layer D15. On the assumption that an intermediate layer (passivation layer) is present between the redistribution layer member R15 and the molding layer D15, the through-hole H16 may be formed through the intermediate layer (passivation layer) while being formed through the molding layer D15.

Referring to FIG. 17C, a thermal interface material member T17 configured to at least partially cover the plurality of unit device regions U10 in contact with a backside of each of the plurality of chips C15 may be formed on the molding layer D15. The through-hole H16 may be filled with a material of the thermal interface material member T17. The thermal interface material member T17 may be connected to (in contact with) the conductive contact element CE15 via the through-hole H16.

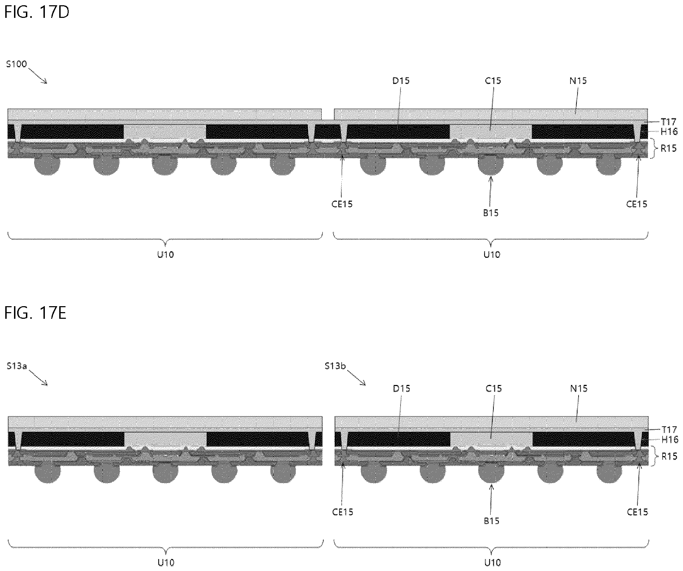

Referring to FIG. 17D, a heat spreading member N15 configured to at least partially cover the plurality of unit device regions U10 may be formed on the thermal interface material member T17. For each of the plurality of unit device regions U10, the heat spreading member N15 may be formed on the thermal interface material member T17. The heat spreading member N15 may be thermally connected or thermally and electrically connected to the at least one conductive contact element CE15 through the at least one through-hole H16. If the thermal interface material member T17 is made of a non-conductive (electrically non-conductive) material, the heat spreading member N15 may be thermally connected to the conductive contact element CE15 through the through-hole H16.

Referring to FIG. 17E, the device structure S100 (FIG. 17D) in which the thermal interface material member T17 and the heat spreading member N15 are formed may be divided (cut) into package devices corresponding respectively to the plurality of unit device regions U10. As a result, individual semiconductor package devices S13a and S13b may be obtained. Each of the semiconductor package devices S13a and S13b may have the configuration described with reference to FIG. 8.

According to the embodiment, the at least one conductive contact element CE15 may include, for example, a stacked via structure. For each of the plurality of unit device regions U10, the at least one conductive contact element CE15 may be a single conductive contact element, and the single conductive contact element may have a ring structure surrounding the active region (see FIG. 10). Alternatively, for each of the plurality of unit device regions U10, the at least one conductive contact element CE15 may include a plurality of conductive contact elements disposed around the active region so as to be spaced apart from each other (see FIG. 11).

Additionally, each of the plurality of chips may be disposed in a corresponding one of the plurality of unit device regions U10 (see FIGs. 12 and 13). Furthermore, all of the features described with reference to FIGs. 1 to 3 may be applied to the method of manufacturing the semiconductor package device according to the embodiment of the present invention.

According to the embodiments of the present invention described above, it is possible to provide a semiconductor package device capable of improving thermal performance or thermal/electrical performance while increasing manufacturing efficiency and a method of manufacturing the same. In addition, according to the embodiments of the present invention described above, it is possible to provide a semiconductor package device capable of effectively improving thermal performance or thermal/electrical performance, for example, in a fan-out package, and a method of manufacturing the same.

According to an embodiment, for example, in a fan-out semiconductor package, it is possible to improve thermal performance using a thermal interface material (TIM) member in contact with a backside of a chip and a heat spreading member disposed on the thermal interface material member. In addition, according to an embodiment, it is possible to improve thermal/electrical performance of a package device using thermal/electrical connection by a through mold via (TMV) in conjunction with the thermal interface material (TIM) member and the heat spreading member.

The technology according to the embodiments of the present invention may be applied to a panel level package (PLP) or a wafer level package (WLP), and may also be applied to a single chip (die) package or a multi-chip (multi-die) package. The technology according to the embodiments may be usefully applied to various advanced packaging fields.

However, the effects of the present invention are not limited to the above effects, and may be variously expanded without departing from the technical ideas and scope of the present invention.

Preferred embodiments of the present invention have been disclosed herein, and although certain terms are used, they are used in a general sense to facilitate the description and understanding of the invention, and are not intended to limit the scope of the invention. In addition to the embodiments disclosed herein, other modifications based on the technical ideas of the present invention will be apparent to those skilled in the art to which the present invention pertains. It will be apparent to those skilled in the art that the semiconductor package device and the method of manufacturing the same according to the embodiments described with reference to FIGs. 1 to 17E may be subject to various substitutions, changes, and modifications without departing from the technical ideas of the present invention. The scope of the invention is therefore not to be defined by the embodiments described above but by the technical ideas recited in the appended claims.

## Claims

1. A semiconductor package device comprising:
a redistribution layer member;
at least one chip disposed on a first surface of the redistribution layer member, the at least one chip being electrically connected to the redistribution layer member;
a molding layer disposed on the first surface of the redistribution layer member so as to at least partially expose a backside of the at least one chip while filling a space around the at least one chip;
a thermal interface material member disposed on the molding layer in contact with the backside of the at least one chip; and
a heat spreading member disposed on the thermal interface material member.

2. The semiconductor package device according to claim 1, wherein the backside of the chip and a surface of the molding layer are disposed on the same plane.

3. The semiconductor package device according to claim 1, wherein
the molding layer is formed on the first surface of the redistribution layer member with a larger thickness than the chip so as to cover the chip, and
an opening configured to expose the backside of the chip is formed in the molding layer.

4. The semiconductor package device according to any one of claims 1 to 3, wherein
the redistribution layer member comprises at least one conductive contact element provided around an active region,
at least one through-hole configured to expose the at least one conductive contact element is formed in the molding layer or a stack of the molding layer and the thermal interface material member, and
the through-hole is filled with a material of the thermal interface material member or a material of the heat spreading member.

5. The semiconductor package device according to claim 4, wherein the heat spreading member is thermally connected or thermally and electrically connected to the at least one conductive contact element through the at least one through-hole.

6. The semiconductor package device according to claim 4, wherein the at least one conductive contact element comprises a stacked via structure.

7. The semiconductor package device according to claim 4, wherein
the at least one conductive contact element is a single conductive contact element, and
the single conductive contact element has a ring structure surrounding the active region.

8. The semiconductor package device according to claim 4, wherein the at least one conductive contact element comprises a plurality of conductive contact elements disposed around the active region so as to be spaced apart from each other.

9. The semiconductor package device according to claim 1, wherein the heat spreading member comprises a non-conductive material or a conductive material.

10. The semiconductor package device according to claim 1, wherein the heat spreading member comprises a conductive material and is used as an electrical connection member.

11. The semiconductor package device according to claim 1, wherein a plurality of electrical connection elements is disposed on a second surface of the redistribution layer member, the second surface being opposite the first surface.

12. The semiconductor package device according to claim 1, wherein the semiconductor package device has a fan-out package structure.

13. A method of manufacturing a semiconductor package device, the method comprising:
preparing a device structure comprising a redistribution layer member, a plurality of chips, and a molding layer, wherein the redistribution layer member has a plurality of unit device regions, the plurality of chips is disposed on a first surface of the redistribution layer member so as to be electrically connected to the redistribution layer member, and the molding layer is disposed on the first surface of the redistribution layer member so as to at least partially expose a backside of each of the plurality of chips while filling spaces around the plurality of chips;
forming a thermal interface material member configured to at least partially cover the plurality of unit device regions in contact with the backside of each of the plurality of chips on the molding layer;
forming a heat spreading member configured to at least partially cover the plurality of unit device regions on the thermal interface material member; and
dividing the device structure having the thermal interface material member and the heat spreading member formed therein into package devices corresponding respectively to the plurality of unit device regions.

14. The method according to claim 13, wherein, in the step of preparing the device structure, an initial molding layer configured to cover the plurality of chips is formed, and a grinding or ablation process is performed on the initial molding layer to expose the backside of each of the plurality of chips.

15. The method according to any one of claims 13 to 14, wherein
the redistribution layer member comprises at least one conductive contact element provided around an active region for each of the plurality of unit device regions,
at least one through-hole configured to expose the at least one conductive contact element is formed in the molding layer or a stack of the molding layer and the thermal interface material member for each of the plurality of unit device regions, and
the through-hole is filled with a material of the thermal interface material member or a material of the heat spreading member.
